# EUROPÄISCHE PATENTSCHRIFT

(11) **EP 1 554 417 B1**
(45) Veröffentlichungstag und Bekanntmachung des Hinweises auf die Patenterteilung: **06.08.2008**
(21) Anmeldenummer: 03808707.8
(22) Anmeldetag: 02.10.2003
(51) Int. Cl.: C30B 25/14, C30B 25/08, C23C 16/448

(54) **HYDRID VPE REAKTOR UND VERFAHREN**
HYDRIDE VPE REACTOR AND PROCESS
REACTEUR DE VPE A HYDRURE ET PROCEDE

(30) Priorität: 10.10.2002 DE 10247921
(43) Veröffentlichungstag der Anmeldung: 20.07.2005
(73) Patentinhaber: Aixtron AG, 52072 Aachen (DE)
(72) Erfinder: KÄPPELER, Johannes, 52146 Würselen (DE)
(74) Vertreter: Grundmann, Dirk
(86) Internationale Anmeldenummer: PCT/EP2003/010953
(87) Internationale Veröffentlichungsnummer: WO 2004/035878

(56) Entgegenhaltungen:
- WO-A-02/18680
- WO-A-85/03727
- DE-A- 2 743 836
- DE-A- 2 743 909
- DE-A- 10 118 130
- US-A- 4 000 716

## Beschreibung

Die Erfindung betrifft eine Vorrichtung zum Abscheiden insbesondere kristalliner Schichten auf insbesondere kristallinen Substraten aus der Gasphase, mit einer beheizten Prozesskammer mit einem Substrathalter zur Aufnahme mindestens eines Substrates, mit einer oder mehreren beheizten Quellen, wo durch chemische Reaktion eines zusammen mit einem Trägergas der Quelle zugeleiteten Halogens, insbesondere HCl und eines der Quelle zugeordneten Metalls, beispielsweise Ga, In, Al, ein gasförmiges Halogenid entsteht, welches durch ein Gaseinlaßorgan zu einem von einem sich in der Horizontalebene erstrekkenden Substrathalter getragenen Substrat transportiert wird, und mit einer Hydridzuleitung zum Zuleiten eines Hydrids, insbesondere NH₃, AsH₃ und/oder PH₃ in die Prozesskammer.

Die Erfindung betrifft darüber hinaus ein Verfahren zum Abscheiden insbesondere kristalliner Schichten auf insbesondere kristallinen Substraten aus der Gasphase, wobei das mindestens eine Substrat auf einem Substrathalter liegt und in einer oder mehreren beheizten Quellen durch chemische Reaktion eines zusammen mit einem Trägergas der Quelle zugeleiteten Halogens, insbesondere HCl, mit einem der Quelle zugeordneten Metalls, beispielsweise Ga, In, Al, ein gasförmiges Halogenid erzeugt wird, welches durch ein Gaseinlaßorgan zu einem von dem sich in der Horizontalen erstreckenden Substrathalter getragenen Substrat transportiert wird, wobei durch eine Hydridzuleitung ein Hydrid, insbesondere NH₃, AsH₃ oder PH₃ in die Prozesskammer geleitet wird.

Derartige Vorrichtungen bzw. auf solchen Vorrichtungen angewandte Verfahren dienen unter anderem dazu, Pseudosubstrate abzuscheiden. Sie dienen aber auch dazu, Schichten bzw. Schichtenfolgen für elektronische Bauelemente abzuscheiden, wobei die Schichten aus Materialien der dritten und der fünften Hauptgruppe bestehen. Die Schichten können dotiert werden. Die Herstellung von Pseudosubstraten bietet sich bei diesem Prozess an, da Wachstumsraten größer 200 Mikrometer pro Stunde erzielbar sind. Insbesondere werden für die Herstellung von Leuchtdioden auf der Basis von GaN derartige Pseudosubstrate benötigt. Einzelheiten dazu werden in der DE 101 18 130.2 beschrieben. Diese Patentanmeldung befaßt sich mit der Anordnung der Quellenzone im Zentrum eines in der Horizontalebene liegenden Substrathalters.

US-A-4000716 beschriebt eine HVPE Vorrichtung mit einem Gaseinlaßorgan. Zu diesem Gaseinlaßorgan ist eine Quelle geordnet.

Ausgehend von dem eingangs umrissenen Stand der Technik liegt der Erfindung die Aufgabe zugrunde, eine Vorrichtung bzw. ein Verfahren anzugeben, mit welcher bzw. welchem mit hoher Wachstumsrate auf geeigneten Substraten das Wachstum von Schichten insbesondere zur Verwendung als Pseudosubstrate zum nachträglichen Abscheiden von GaN-Schichten möglich sind.

Gelöst wird die Aufgabe durch die in den Ansprüchen angegebene Vorrichtung bzw. durch das dort angegebene Verfahren.

Wesentliches Lösungsmerkmal ist die Trennung von Substratheizung und Prozesskammerheizung derart, dass die Quellen separat von der Prozesskammer beheizt werden können. Dies wird unter anderem dadurch erreicht, dass der Substrathalter eine Vertikalachse aufweist, um welche eine Vielzahl von Substraten anordbar sind. Das Gaseinlaßorgan erstreckt sich entlang der Vertikalachse. In der Projektion auf die Horizontalebene, in welcher der Substrathalter liegt, liegen die Quellen somit innerhalb des zentralen Zwischenraums zwischen den Substraten. Die Substrate sind (in der Projektion) somit gleichsam um die Quelle angeordnet, wobei sich die Quellenzone aber oberhalb der Prozesskammer befinden soll. Die Quellen sind dem Gaseinlaßorgan zugeordnet. Die Quellenzone, die oberhalb der Prozesskammer liegt, kann mittels einer gesonderten Heizung separat beheizt werden. Vorzugsweise erfolgt die Beheizung der Prozesskammer mittels HF-Spulen. Eine von zwei Spulen kann oberhalb einer Decke der Prozesskammer angeordnet sein. Eine zweite HF-Spule kann unterhalb der Prozesskammer angeordnet sein, um so direkt den Boden der Prozesskammer, welcher vom Substrathalter gebildet wird, zu beheizen. Die Heizung für die Quellenzone des Gaseinlaßorganes kann von einer Heizmanschette gebildet werden. Diese kann eine Widerstandsheizung aufweisen. Die Heizmanschette umgibt den Abschnitt des Gaseinlaßorganes, in welchem die Metallquellen angeordnet sind. Vorzugsweise bildet die Quellenzone einen rohrförmigen Abschnitt aus. Die einzelnen Quellen werden getrennt voneinander mit einem Trägergas und vom Trägergas transportierten Chlorid versorgt. Dieses Chlorid kann HCl sein. Die Versorgung der Quellen erfolgt mittels ineinander geschachtelter Zuleitungsrohre. Diese Zuleitungsrohre münden jeweils in einem Quellentopf, in welchem sich das flüssige Metall befindet. Die Mündung der Zuleitung kann oberhalb des Flüssigkeitsspiegels liegen. Auch die Ableitungsrohre der Quellen sind ineinander geschachtelt. Durch eine zentrale Zuleitung, die durch sämtliche Quellentöpfe hindurchragt, wird das Hydrid zugegeben. Die einzelnen ringförmigen Quellentöpfe liegen übereinander. Um die Quellenzone thermisch von der Prozesskammer zu trennen, ist ein Wärmeisolationskörper vorgesehen. Dieser liegt auf dem zentralen Abschnitt der Prozesskammerdecke auf. Die zuvor beschriebenen Zu- und Ableitungsrohre werden von ineinander geschachtelten Rohrkörpern gebildet. Diese Rohrkörper bilden jeweils die Wände für die Zu- bzw. Ableitungsrohre aus. Darüber hinaus bilden die Rohrkörper auch die Quellentöpfe aus. Die Rohrkörper können aus miteinander verschmolzenen Quarzrohren bestehen. Auslaßseitig können die Ableitungsrohre tellerförmige Enden aufweisen. Mittels dieser Enden werden die Metallhydride und die Trägergase von einer vertikalen Stromrichtung innerhalb der Quellenzone radial auswärts umgelenkt in eine Horizontalströmung. Die tellerförmigen Enden münden bevorzugt in eine Ringkammer der Prozesskammerdecke. Bis dorthin werden die Metallchloride getrennt voneinander transportiert. Diese Ringkammer wird nach unten, also zur Prozesskammer, von einer Wandung begrenzt. Diese Wandung besitzt eine zentrale Öffnung, durch welche das Hydrid aus der Hydridleitung in die Prozesskammer strömen kann. In der Peripherie besitzt diese Wandung eine Vielzahl von Austrittsöffnungen, die sich ringförmig etwa im Bereich oberhalb der Substrate um das Zentrum erstrecken. Durch diese siebartigen Austrittsöffnungen können die Chloride in die Prozesskammer hineinströmen. Um die Temperatur des Substrathalters bestimmen zu können, sind insbesondere optische Sensoren vorgesehen. So kann ein optischer Sensor die Ringkammer durchragen. Dieser optische Sensor befindet sich bevorzugt unmittelbar über dem Radialbereich, in welchem die Substrate angeordnet sind. Somit kann mittels dieses Sensors nicht nur die Oberflächentemperatur des Substrathalters optisch bestimmt werden. Mit diesem Sensor können auch optisch ermittelbare Eigenschaften des mindestens einen Substrates ermittelt werden. Es ist ferner von Vorteil, wenn die Prozesskammer und das Gaseinlaßorgan in einem Reaktorgehäuse angeordnet sind. Dabei kann das Zentrum des Deckels des Reaktorgehäuses einen Flanschabschnitt aufweisen, in den ein Teilbereich der Quellenzone hineinragen kann. Dieser Flanschabschnitt kann mit einem Verschluß verschlossen sein. Dieser Verschluß besitzt einen gemeinsamen Anschluß für sämtliche Zuleitungen, die gestuft die Öffnung des Flanschabschnittes überragen. Die Abdichtung zu den Mündungen der Zuleitungen erfolgt durch O-Ringe, die jeweils die Endabschnitte der Rohre umfassen.

Ausführungsbeispiele der Erfindung werden nachfolgend anhand beigefügter Zeichnungen erläutert. Es zeigen:
- Fig. 1: ein Reaktorgehäuse im Halbschnitt mit darin angeordneter Prozesskammer und oberhalb der Prozesskammer angeordnetem Gaseinlaßorgan mit separat beheizter Quellenzone,
- Fig. 2: einen vergrößerten Abschnitt des Gaseinlaßorganes und dessen Quellenzone,
- Fig. 3: eine schematische Darstellung der Temperaturen von Quelle und Prozesskammer und
- Fig. 4: ausschnittsweise den linken Bereich des Zentrums der Prozesskammer eines zweiten Ausführungsbeispiels.

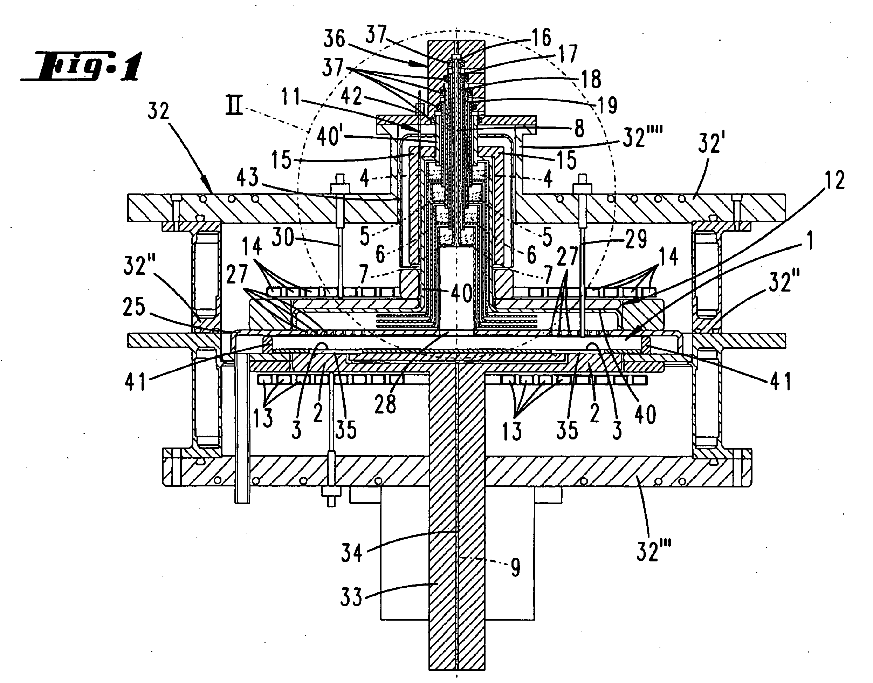

Die in der Figur 1 im Halbschnitt dargestellte Vorrichtung besitzt eine nahezu Rotationssymmetrie um die Vertikalachse 9. Es handelt sich um ein Reaktorgehäuse 32, welches eine ringförmige Wandung 32" aufweist, einen Boden 32"', der die Reaktionskammer nach unten begrenzt, und einen Reaktordeckel 32', der die Reaktorkammer nach oben begrenzt. Der Deckel 32' besitzt in der Mitte einen Flanschabschnitt 32"", der von einem Anschlußflansch 36 verschlossen werden kann. In der Mitte, also im Bereich der Vertikalachse 9, befindet sich eine Durchbrechung des Bodens 32"', durch welche eine Antriebswelle 33 ragt, zum Drehantreiben eines Substrathalters 2.

Der Substrathalter 2 begrenzt eine etwa in der Mitte der Reaktionskammer angeordnete Prozesskammer 1 nach unten. Seitlich wird die Prozesskammer 1 von einem Außenring 41 umgrenzt. Über diesen erfolgt auch eine Gasableitung aus der Prozesskammer. Nach oben wird die Prozesskammer 1 von einer Prozesskammerdecke 12 begrenzt. Die zur Prozesskammer 1 weisende Oberfläche des Substrathalters 2 besitzt eine Vielzahl von ringförmig um das Zentrum angeordnete Vertiefungen. In jeder dieser Vertiefungen liegt ein Substratträger 35 ein. Mittels eines durch eine Gasleitung 34 zugeführten Gases kann jeder der Substratträger 35 in Drehung versetzt werden. Dadurch rotiert jedes auf einem Substratträger 35 aufliegende Substrat 3 um seine eigene Achse.

Zwischen den ringförmig angeordneten Substraten 3 bzw. dem ringförmig angeordneten Substratträger 35 befindet sich ein zentraler Freiraum. Der Durchmesser dieses zentralen Freiraums ist im Ausführungsbeispiel größer als der Durchmesser der oberhalb der Prozesskammerdecke 12 angeordneten Quellenzone 11.

Die Quellenzone 11 wird von einem Gaseinlaßorgan 10 ausgebildet. Das Gaseinlaßorgan 10 befindet sich unterhalb des Anschlußflansches 36. In der Quellenzone 11 befinden sich die axial übereinander angeordneten Quellen 4, 5, 6 und 7. Um die Quellen 4, 5, 6, 7 auf die Quellentemperatur Ts aufzuheizen, ist eine Heizmanschette 15 vorgesehen, die die gesamte Quellenzone umgibt. Die Heizmanschette 15 wird widerstandsbeheizt.

Zur Beheizung der Prozesskammer 1 dienen zwei wassergekühlte HF-Spulen 13,14. Die HF-Spule 14 ist oberhalb der Prozesskammerdecke 12 angeordnet. Die HF-Spule 13 ist unterhalb des Substrathalters 2 angeordnet. Im Zentrum der oberhalb der Prozesskammerdecke 12 angeordneten HF-Spule befindet sich ein auf der Prozesskammerdecke 12 aufliegender Quarzring 24. Dieser Quarzring 24 bildet einen Wärmeisolierungskörper aus. Oberhalb des Wärmeisolierungskörpers 24 befindet sich unter einer Glocke 43 die bereits erwähnte Heizmanschette 15. Die Heizmanschette 15 umgibt einen Hülsenkörper 40, der mit seinem einen Ende 40' in einer Öffnung des Anschlußflansches 36 steckt und dort mittels eines O-Ringes abgedichtet ist. Das andere Ende 40" des aus Quarz bestehenden Hülsenkörpers 40 bildet eine Wandung einer Ringkammer 26 der Prozesskammerdecke 12. Die andere Wandung der Ringkammer 26 wird von einer Quarzplatte 25 ausgebildet, die eine zentrale Öffnung 28 aufweist und die eine Vielzahl von peripheren Öffnungen 27 aufweist, die oberhalb der Substrate 3 angeordnet sind.

Im Inneren des mittleren Abschnittes des Hülsenkörpers 40 befinden sich mehrere ineinander geschachtelte Rohrkörper aus Quarz. Diese Rohrkörper bilden einerseits die Zuleitungen zu den Quellen 4, 5, 6, 7 und andererseits die Ableitungen, durch welche die in den Quellen gebildeten Metallchloride zusammen mit den Trägergasen in die Ringkammer 26 transportiert werden.

Dabei werden die Zuleitungsrohre 16, 17, 18,19 von ineinander geschachtelten Quarzrohrabschnitten der Rohrkörper gebildet. Dabei ist das innere Rohr 16, durch welches das Hydrid strömt, am längsten. Die das innere Rohr 16 umgebenden Rohre 17,18,19 münden jeweils gestuft zueinander, so dass die jeweiligen Enden der Rohre 16,17,18,19 mittels O-Ringen 37 gegenüber dem Anschlußflansch 36 abgedichtet werden können. Die gestuften Rohrenden ragen dabei in eine gestufte Öffnung des Anschlußflansches 36 hinein. Die Zuführung der Chloride erfolgt durch Rohranschlüsse 38 jeweils gesondert zu einem der Zuleitungsrohre 16,17,18 und 19.

Die ineinander geschachtelten Zuleitungsrohre 16 bis 19 münden in topfförmige Quellen, die ringförmig die Hydridzuleitung 8 umgeben. Jeder Quellentopf wird von einem der Rohrkörper ausgebildet. Die Außenwandung der Quellentöpfe, die axial übereinander angeordnet sind, werden von durchmessergrößeren, ebenfalls ineinander geschachtelten Rohrabschnitten ausgebildet, welche Ableitungsrohre 20, 21, 22, 23 ausbilden, die ebenfalls ineinander geschachtelt sind. Die Enden der Ableitungsrohre 21', 22' und 23' sind tellerförmig aufgeweitet, so dass die durch die Ableitungsrohre 20 bis 23 strömenden Chloride umgeleitet werden und in eine gemeinsame Kammer 26 strömen. Das Innere Ableitungsrohr 20 ist seinem Ende mit der Prozesskammerwandung 25 verbunden. Mehrere aus den Enden der Ableitungsrohre 21' bis 23' ausströmende Chloride werden in der Ringkammer 26 miteinander vermischt und treten durch die Vertikalöffnungen 27 oberhalb der Substrate in die Prozesskammer 1 ein. Die Zuführung der Hydride erfolgt durch die zentrale Austrittsöffnung 28. Dies hat zur Folge, dass die Hydride eine längere Zeit durch die Prozesskammer 1 strömen als die Chloride. Auch die Strömungsrichtung der Hydride verläuft senkrecht zur Strömungsrichtung der Chloride.

Im Deckel 32' des Reaktorgehäuses 32 befinden sich Sensoren 29 und 30. Der Sensor 29 ist ein optischer Sensor zur Bestimmung der Reflektivität und der Temperatur der Substrate 3. Hierzu durchragt der Sensor 29 die Ringkammer 26 und mündet in der Prozesskammerwandung 25. Der Temperatursensor 30 durchragt lediglich die HF-Spule 14, um damit die Temperatur der Prozesskammerdecke 12 zu ermitteln.

Auch dem Boden 32'" ist ein Sensor 31 zugeordnet. Dieser Temperatursensor 31 durchragt die untere HF-Spule 13, um die Temperatur des Substrathalters 2 zu ermitteln.

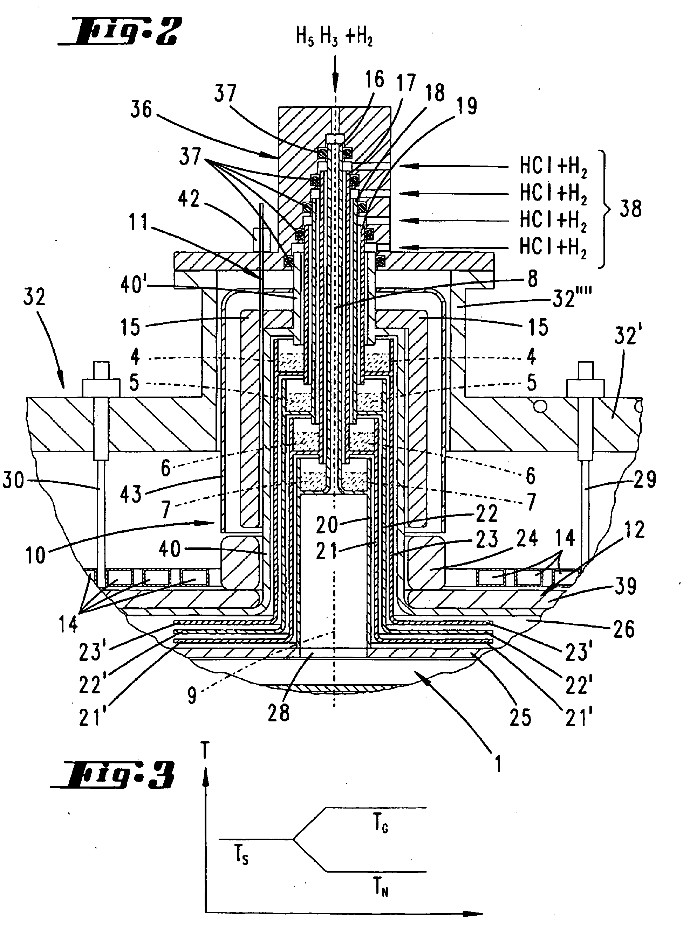

Wie aus der Figur 3 hervorgeht, wird die Quelle bei einer Temperatur T_{S} betrieben. Diese konstante Quellentemperatur kann zwischen 800° und 900° C liegen. Um auf einem der Substrate (Al₂O₃, Si etc.) eine Nucleationsschicht abzuscheiden, wird die Prozesskammer auf eine Temperatur T_{N} gebracht, die etwa zwischen 450° und 500° Celsius liegt. Nach Abscheiden der Nucleationsschicht wird die Prozesskammer auf eine Wachstumstemperatur T_{G} aufgeheizt, die je nach Anwendung zwischen 700° und 1.200° C liegt. Bei dieser Wachstumstemperatur T_{G} kann GaN abgeschieden werden. Durch die Verwendung einer HF-Heizung, die zudem wassergekühlt ist, um die Prozesskammer 1 zu beheizen, kann diese nicht nur relativ schnell aufgeheizt, sondern auch relativ schnell abgekühlt werden. Da die Quellenzone 11 bei im Wesentlichen konstanter Temperatur Ts betrieben wird, kann diese widerstandsbeheizt werden. In dem darüber hinaus die Prozesskammerdecke 12 von einer separaten HF-Heizung 14 aufgeheizt wird, kann durch verschiedenartige Ansteuerung der HF-Spulen 13, 14 innerhalb der Prozesskammer ein vertikaler Temperaturgradient erzeugt werden. Dies kann vorteilhaft sein, wenn eine Übersättigung der Gasphase erzeugt werden soll.

Mit der zuvor beschriebenen Vorrichtung ist auch eine Dotierung der abgeschiedenen Halbleiterschichten möglich. Dabei ist insbesondere vorgesehen, dass die Dotierstoffe über die Hydridleitung in die Prozesskammer geleitet werden. Es ist aber auch vorgesehen, dass der Dotierstoff als flüssiges Metall in einem der Quellentöpfe zur Verfügung gestellt wird.

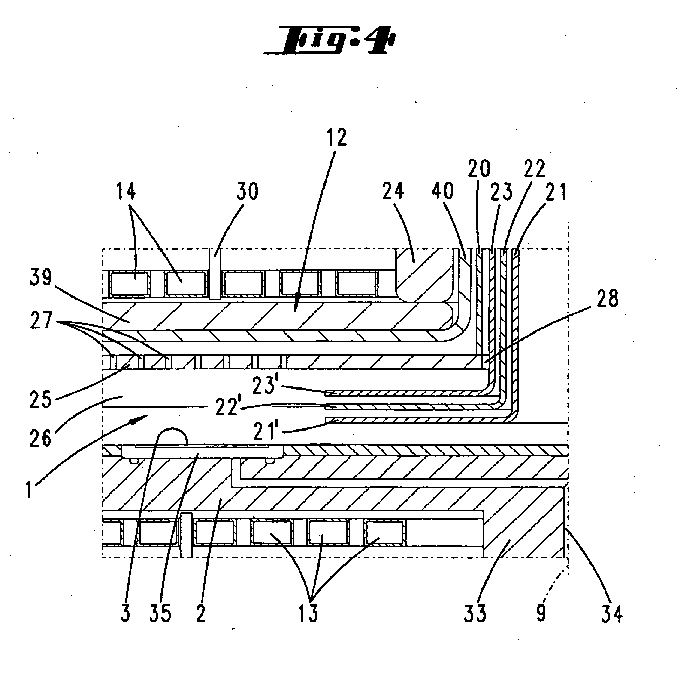

Alternativ zu der in den Figuren 1 und 2 dargestellten Vorrichtung, bei der die Hydridleitung 8 im Zentrum des Gaseinlasßorganes verläuft, ist es auch vorgesehen, die Hydride außen um die Zu- und Ableitungen zu den Metallquellen herumzuleiten. Bei dieser in der Figur 4 dargestellten Ausgestaltung durchragen die Rohre 21, 22, 23 die Prozesskammerwandung 25 und ragen in die Prozesskammer hinein. Dort befinden sich die tellerförmigen Enden 21', 22', 23'. In diesem Ausführungsbeispiel strömt allein das Hydrid, ggf. mit Dotierstoffen in die oberhalb der Prozesskammerdecke liegende Ringkammer 26. Aus dieser Ringkammer 26 strömen die Hydride zusammen mit einem eventuellen Dotierstoff durch die Durchtrittsöffnungen 27 von oben in die Prozesskammer. Bei dieser, in der Figur 4 dargestellten Ausgestaltung strömen die Metallchloride in vertikaler Richtung dem Substrat 3 zu. Die Hydride strömen von oben in die Prozesskammer 1.

## Patentansprüche

1. Vorrichtung zum Abscheiden insbesondere kristalliner Schichten auf insbesondere kristallinen Substraten aus der Gasphase, mit einer beheizten Prozesskammer (1) mit einem Substrathalter (2) zur Aufnahme mindestens eines Substrates (3), mit einer oder mehreren beheizten Quellen (4), wo durch chemische Reaktion eines zusammen mit einem Trägergas der Quelle zugeleiteten Halogens, insbesondere HCl und eines der Quelle (4 bis 7) zugeordneten Metalls, beispielsweise Ga, In, Al, ein gasförmiges Halogenid entsteht, welches durch ein Gaseinlaßorgan (10) zu einem von einem sich in der Horizontalebene erstreckenden Substrathalter (2) getragenen Substrat (3) transportiert wird, und mit einer Hydridzuleitung (8) zum Zuleiten eines Hydrids, insbesondere NH₃, AsH₃ und/oder PH₃ in die Prozesskammer, **dadurch gekennzeichnet, dass** der Substrathalter (2) eine Vertikalachse (9) aufweist, um welche eine Vielzahl von Substraten anordbar sind, und dass das Gaseinlaßorgan (10) sich entlang der Vertikalachse (9) erstreckt, wobei die im Gaseinlaßorgan (10) angeordneten Quellen (4 bis 7) in einer oberhalb der den Substrathalter (2) aufnehmenden Prozesskammer (1) sich erstreckenden Zone (11) des Gaseinlaßorgans (10) angeordnet sind und mit einer dieser Quellenzone (11) zugeordneten Heizung (15) von der Prozesskammer (1) separat beheizbar sind.

2. Verfahren zum Abscheiden insbesondere kristalliner Schichten auf insbesondere kristallinen Substraten aus der Gasphase, wobei das mindestens eine Substrat auf einem Substrathalter (2) liegt und in einer oder mehreren beheizten Quellen (4 bis 7) durch chemische Reaktion eines zusammen mit einem Trägergas der Quelle (4 bis 7) zugeleiteten Halogens, insbesondere HCl, mit einem der Quelle (4 bis 7) zugeordneten Metalls, beispielsweise Ga, In, Al, ein gasförmiges Halogenid erzeugt wird, welches durch ein Gaseinlaßorgan (5) zu einem von dem sich in der Horizontalen erstreckenden Substrathalter (2) getragenen Substrat transportiert wird, wobei durch eine Hydridzuleitung (8) ein Hydrid, insbesondere NH₃, AsH₃ oder PH₃ in die Prozesskammer geleitet wird, **dadurch gekennzeichnet, dass** die im Gaseinlaßorgan (10) oberhalb eines Zentrums des Substrathalters (2) angeordnete Quelle (4 bis 7) separat von der Prozesskammer (1) beheizt wird und mehrere Substrate (3) um das Zentrum des Substrathalter (2) angeordnet werden.

3. Vorrichtung nach Anspruch 1, **gekennzeichnet durch** eine unterhalb eines Bodens (Substrathalter 2) der Prozesskammer (1) und oberhalb einer Decke (12) der Prozesskammer (1) angeordnete, insbesondere wassergekühlte HF-Spule (13, 14) zum Beheizen der Prozesskammer (1).

4. Vorrichtung nach einem der vorhergehenden Ansprüche, **gekennzeichnet durch** eine die Quellenzone (11) des Gaseinlaßorgans (10) umgebende Heizmanschette (15) insbesondere in Form einer Widerstandsheizung.

5. Vorrichtung nach einem der vorhergehenden Ansprüche, **dadurch gekennzeichnet, dass** mehrere Quellen (4 bis 7) axial übereinander angeordnet sind.

6. Vorrichtung nach einem der vorhergehenden Ansprüche, **gekennzeichnet durch** ineinander geschachtelte Zu- und Ableitungsrohre (16 bis 19; 20 bis 23) zu bzw. von den Quellen (4 bis 7).

7. Vorrichtung nach Anspruch 6, **dadurch gekennzeichnet, dass** die Zu- bzw. Ableitungsrohre (16 bis 19; 20 bis 23) eine zentrale Leitung (8) für das Hydrid umgeben.

8. Vorrichtung nach einem oder mehreren der vorhergehenden Ansprüche, **dadurch gekennzeichnet, dass** die Quellenzone (11) von der Prozesskammerdecke (12) mit einem Wärmeisolationskörper (24) getrennt ist.

9. Vorrichtung nach einem der vorhergehenden Ansprüche, **dadurch gekennzeichnet, dass** das Gaseinlaßorgan (10) eine Vielzahl von ineinander geschachtelten Rohrkörpern aufweist, die jeweils die Wände für die Zu- bzw. Ableitungsrohre (16 bis 19; 20 bis 23) und Töpfe für die Quellen (4 bis 7) ausbilden.

10. Vorrichtung nach einem der vorhergehenden Ansprüche, **dadurch gekennzeichnet, dass** die Ableitungsrohre (20 bis 23) endseitig tellerförmige Enden (25, 21' bis 23') aufweisen.

11. Vorrichtung nach Anspruch 10, **dadurch gekennzeichnet, dass** die tellerförmigen Enden (21' bis 23') in einer Ringkammer (26) der Prozesskammerdecke (12) angeordnet sind.

12. Vorrichtung nach einem der vorhergehenden Ansprüche, **dadurch gekennzeichnet, dass** die die Prozesskammer (1) nach oben begrenzende Wandung (25) der Ringkammer (26) periphere Austrittsöffnungen (27) für die Chloride und eine zentrale Austrittsöffnung (28) für das Hydrid aufweist.

13. Vorrichtung nach einem der vorhergehenden Ansprüche, **dadurch gekennzeichnet, dass** die die Prozesskammer (1) nach oben begrenzende Wandung (25) der Ringkammer (26) periphere Austrittsöffnungen (27) für das Hydrid aufweist und die Chloride durch eine zentrale Öffnung der Wandung (25) ins Zentrum der Prozesskammer gebracht werden, wo sie in eine horizontale Strömungsrichtung umgelenkt werden.

14. Vorrichtung nach einem der vorhergehenden Ansprüche, **gekennzeichnet durch** einen **durch** die Ringkammer (26) ragenden Sensor (29) zur Temperaturmessung des Substrathalters (2) und/oder zur Messung optischer Eigenschaften der Substrate (3).

15. Vorrichtung nach einem der vorhergehenden Ansprüche, **dadurch gekennzeichnet, dass** die Prozesskammer (1) und das Gaseinlaßorgan (10) in einem Reaktorgehäuse (32) angeordnet sind.

16. Verfahren nach Anspruch 2, **dadurch gekennzeichnet, dass** die Prozesskammer (1) zum Abscheiden einer Nucleationsschicht auf den Substraten (3) auf eine Wachstumstemperatur T_{N} aufgeheizt wird, welche niedriger ist als die Quellentemperatur T_{S} und nach Abscheiden der Nucleationsschicht auf eine Wachstumstemperatur T_{G} aufheizbar ist, welche höher ist als die Quellentemperatur Ts.

17. Verfahren nach einem der vorhergehenden Ansprüche, **dadurch gekennzeichnet, dass** der Substrathalter beim Wachstumsprozess gedreht wird.

18. Verfahren nach einem der vorhergehenden Ansprüche, **dadurch gekennzeichnet, dass** die Substrate (3) auf kreisscheibenförmigen Substratträgern (35) aufliegen, welche um ihre Achse drehangetrieben werden.

19. Vorrichtung nach einem der vorhergehenden Ansprüche, **dadurch gekennzeichnet, dass** die gestuft zueinander angeordneten Mündungen der Zuleitungsrohre (16 bis 19) von einem gemeinsamen Anschlussflansch (36) verschlossen werden, wobei die ineinander geschachtelten Rohre (16 bis 19) mittels O-Ringen (37) abgedichtet werden.

## Claims

1. Apparatus for depositing, from the gas phase, layers on substrates, in particular crystalline layers on in particular crystalline substrates, the apparatus comprising a heated process chamber (1) having a substrate holder (2) for receiving at least one substrate (3), the apparatus comprising one or more heated sources (4) where a gaseous halide is formed by chemical reaction of a halogen and a metal assigned to the source (4 to 7), the halogen being in particular HCl and supplied to the source together with a carrier gas, and the metal being, for example, Ga, In, Al, the halide being transported through a gas inlet element (10) to a substrate carried by a substrate holder (2) extending in the horizontal plane, and the apparatus comprising a hydride feed line (8) for supply of a hydride to the process chamber, the hydride being in particular NH₃, AsH₃, and/or PH₃, **characterized in that** the substrate holder (2) has a vertical axis (9), around which a plurality of substrates can be arranged, and that the gas inlet element (10) extends along the vertical axis, the sources (4 to 7) disposed in the gas inlet element (10) being disposed in a zone (11) of the gas inlet element (10), the zone (11) extending above the process chamber (1) that accommodates the substrate holder (2) and being heatable separately from the process chamber (1) by a heater (15) assigned to this source zone (11).

2. Method for depositing, from the gas phase, layers on substrates, in particular crystalline layers on in particular crystalline substrates, the at least one substrate (3) lying on a substrate holder (2), and a gaseous halide being generated in one or more heated sources (4 to 7) by chemical reaction of a halogen with a metal assigned to the source (4 to 7), the halogen being in particular HCl and supplied to the source (4 to 7) together with a carrier gas, and the metal being, for example, Ga, In, Al, the halide being transported through a gas inlet element (10) to a substrate carried by a horizontally extending substrate holder (2), and a hydride being supplied to the process chamber through a hydride feed line (8), the hydride being in particular NH₃, AsH₃, and/or PH₃, **characterized in that** the source (4 to 7) disposed in the gas inlet element (10) above a centre of the substrate holder (2) are heated separately from the process chamber (1) and a plurality of substrates (3) are disposed around the centre of the substrate holder (2).

3. Apparatus according to Claim 1, **characterized by** HF-windings (13, 14) for heating the process chamber (1), the windings being in particular water-cooled and being disposed beneath a floor (substrate holder 2) of the process chamber (1) and above a cover (12) of the process chamber (1).

4. Apparatus according to any of the preceding claims, **characterized by** a heating sleeve (15) surrounding the source zone (11) of the gas inlet element (10), the heating sleeve being in particular in the form of a resistance heater.

5. Apparatus according to any of the preceding claims, **characterized in that** a plurality of sources (4 to 7) are arranged axially, one above the other.

6. Apparatus according to any of the preceding claims, **characterized by** infeed and outfeed tubes (16 to 19; 20 to 23) to and from the sources (4 to 7), the tubes being nested in one another.

7. Apparatus according to Claim 6, **characterized in that** the infeed and outfeed tubes (16 to 19; 20 to 23) surround a central line (8) for hydride.

8. Apparatus according to one or more of the preceding claims, **characterized in that** the source zone (11) is separated from the process chamber cover (12) by a heat-insulating member (24).

9. Apparatus according to any of the preceding claims, **characterized in that** the gas inlet element (10) has a plurality of tubular members that are nested in one another, each of the tubes forming the walls for the infeed and outfeed tubes (16 to 19; 20 to 23) and pot-like receptacles for the sources (4 to 7).

10. Apparatus according to any of the preceding claims, **characterized in that** the outfeed tubes (20 to 23) have platelike terminations (25, 21' to 23') at their ends.

11. Apparatus according to Claim 10, **characterized in that** the platelike terminations (21' to 23') are disposed in an annular chamber (26) of the process chamber cover (12).

12. Apparatus according to any of the preceding claims, **characterized in that** the wall (25) of the annular chamber (26) that delimits the process chamber (1) at the top has peripheral outlet openings (27) for chloride and a central outlet opening (28) for hydride.

13. Apparatus according to any of the preceding claims, **characterized in that** the wall (25) of the annular chamber (26) that delimits the process chamber (1) at the top has peripheral outlet openings (27) for hydride and chloride is brought into the centre of the process chamber through a central opening in the wall (25), where it is deflected into a horizontal direction of flow.

14. Apparatus according to any of the preceding claims, **characterized by** a sensor (29) projecting through the annular chamber (26) for measuring the temperature of the substrate holder (2) and/or measuring optical properties of the substrate (3).

15. Apparatus according to any of the preceding claims, **characterized in that** the process chamber (1) and the gas inlet element (10) are disposed in a reactor housing (32).

16. Method according to Claim 2, **characterized in that** the process chamber (1) is heated to a growth temperature T_{N} for deposition of a nucleation layer on the substrates (3), the temperature T_{N} being less than the temperature T_{S} of the sources and, after deposition of the nucleation layer, the chamber can be heated to a growth temperature T_{G}, which is higher than the temperature Tₛ of the sources.

17. Method according to one of the preceding claims, **characterized in that** the substrate holder is rotated during the growth process.

18. Method according to one of the preceding claims, **characterized in that** the substrates (3) lie on disk-shaped substrate carriers (35) that are driven in rotation about their axis.

19. Method according to one of the preceding claims, **characterized in that** the mouths of the feed tubes (16 to 19) are closed by a common connecting flange (36), the mouths being arranged stepped relative to each other and the tubes (16 to 19) that are nested in one another being sealed by means of O-rings (37).

## Revendications

1. Dispositif de dépôt de couches, notamment cristallines, sur des substrats, notamment cristallins, à partir de la phase gazeuse, ledit dispositif comportant une chambre de réaction chauffée (1) dotée d'un porte-substrat (2) destiné à recevoir au moins un substrat (3), une ou plusieurs sources chauffées (4), dispositif dans lequel un halogénure sous forme gazeuse, transporté par un organe d'admission de gaz (10) vers un substrat (3) supporté par un porte-substrat (2) s'étendant dans le plan horizontal, est généré par réaction chimique d'un halogène, notamment HCl, amené conjointement avec un gaz de support de la source, et d'un métal, par exemple Ga, In, Al, associé à l'une des sources (4 à 7), et un conduit d'amenée d'hydrure (8) destiné à amener un hydrure, notamment NH₃, AsH₃ et/ou PH₃ dans la chambre de réaction, **caractérisé en ce que** le porte-substrat (2) possède un axe vertical (9) autour duquel une pluralité de substrats peuvent être disposés, et **en ce que** l'organe d'admission de gaz (10) s'étend le long de l'axe vertical (9), les sources (4 à 7) disposées dans l'organe d'admission de gaz (10) étant disposées dans une zone (11) de l'organe d'admission de gaz (10) qui s'étend au-dessus de la chambre de réaction (1) qui reçoit le porte-substrat (2) et pouvant être chauffées séparément de la chambre de réaction (1) au moyen d'un dispositif de chauffage (15) associé à cette zone source (11).

2. Procédé de dépôt de couches, notamment cristallines, sur des substrats, notamment cristallins, à partir de la phase gazeuse, dans lequel au moins un substrat est placé sur un porte-substrat (2) et, dans une ou plusieurs sources chauffées (4 à 7), un halogénure sous forme gazeuse, transporté par un organe d'admission de gaz (5) vers un substrat supporté par le porte-substrat (2) s'étendant dans le plan horizontal, est généré par réaction chimique d'un halogène, notamment HCl, amené conjointement avec un gaz de support de la source (4 à 7), avec un métal, par exemple Ga, In, Al, associé à une des sources (4 à 7), un hydrure, notamment NH₃, AsH₃ ou PH₃ étant amené dans la chambre de réaction par un conduit d'amenée d'hydrure (8), **caractérisé en ce que** la source (4 à 7), disposée dans l'organe d'admission de gaz (10) au-dessus d'un centre du porte-substrat (2), est chauffée séparément de la chambre de réaction (1) et plusieurs substrats (3) sont disposés autour du centre du porte-substrat (2).

3. Dispositif selon la revendication 1, **caractérisé par** une bobine HF (13, 14), notamment refroidie par eau, destinée à chauffer la chambre de réaction (1) et disposée au-dessous d'un fond (porte-substrat 2) de la chambre de réaction (1) et au-dessus d'un couvercle (12) de la chambre de réaction (1).

4. Dispositif selon l'une des revendications précédentes, **caractérisé par** un manchon de chauffage (15), notamment sous forme d'un chauffage par résistance, qui entoure la zone source (11) de l'organe d'admission de gaz (10).

5. Dispositif selon l'une des revendications précédentes, **caractérisé en ce que** plusieurs sources (4 à 7) sont disposées axialement l'une au-dessus de l'autre.

6. Dispositif selon l'une des revendications précédentes, **caractérisé par** des tubes d'amenée et d'évacuation emboîtés (16 à 19 ; 20 à 23) qui mènent aux sources (4 à 7) ou respectivement viennent de celles-ci.

7. Dispositif selon la revendication 6, **caractérisé en ce que** les tubes d'amenée ou d'avacuation (16 à 19 ; 20 à 23) entourent un conduit central (8) destiné à l'hydrure.

8. Dispositif selon l'une ou plusieurs des revendications précédentes, **caractérisé en ce que** la zone source (11) est séparée du couvercle de la chambre de réaction (12) par un corps d'isolation thermique (24).

9. Dispositif selon l'une des revendications précédentes, **caractérisé en ce que** l'organe d'admission de gaz (10) comporte une pluralité de corps tubulaires emboîtés les uns dans les autres, qui forment respectivement les parois des tubes d'amenée ou d'évacuation (16 à 19 ; 20 à 23) et des cuvettes pour les sources (4 à 7).

10. Dispositif selon l'une des revendications précédentes, **caractérisé en ce que** les tubes d'évacuation (20 à 23) comportent des extrémités (25, 21' à 23') en forme de disque.

11. Dispositif selon la revendication 10, **caractérisé en ce que** les extrémités (21' à 23') en forme de disque sont disposées dans une chambre annulaire (26) du couvercle de la chambre de réaction (12).

12. Dispositif selon l'une des revendications précédentes, **caractérisé en ce que** la paroi (25) de la chambre annulaire (26) qui limite vers le haut la chambre de réaction (1) comporte des ouvertures de sortie périphériques (27) destinées aux chlorures et une ouverture de sortie centrale (28) destinée à l'hydrure.

13. Dispositif selon l'une des revendications précédentes, **caractérisé en ce que** la paroi (25) de la chambre annulaire (26) qui limite vers le haut la chambre de réaction (1) comporte des ouvertures de sortie périphériques (27) destinées à l'hydrure et les chlorures sont amenés par une ouverture centrale de la paroi (25) au centre de la chambre de réaction où ils sont déviés dans une direction d'écoulement horizontal.

14. Dispositif selon l'une des revendications précédentes, **caractérisé par** un capteur (29) saillant à travers la chambre annulaire (26) et destiné à mesurer la température du porte-substrat (2) et/ou à mesurer les propriétés optiques des substrats (3).

15. Dispositif selon l'une des revendications précédentes, **caractérisé en ce que** la chambre de réaction (1) et l'organe d'admission de gaz (10) sont disposés dans un boîtier de réacteur (32).

16. Procédé selon la revendication 2, **caractérisé en ce que**, pour déposer une couche de nucléation sur les substrats (3), la chambre de réaction (1) est chauffée à une température de croissance T_{N}, inférieure à la température T_{S} des sources et peut, après dépôt de la couche de nucléation, être chauffée à une température de croissance T_{G}, supérieure à la température T_{S} des sources.

17. Procédé selon l'une des revendications précédentes, **caractérisé en ce que** le porte-substrat est mis en rotation pendant le processus de croissance.

18. Procédé selon l'une des revendications précédentes, **caractérisé en ce que** les substrats (3) reposent sur des porte-substrat (35) en forme de disque circulaire, qui sont entraînés en rotation autour de leur axe.

19. Dispositif selon l'une des revendications précédentes, **caractérisé en ce que** les embouchures des tubes d'amenée (16 à 19), qui sont disposées de façon étagée les unes par rapport aux autres, sont fermées par un flasque de raccordement commun (36), les tubes emboîtés les uns dans les autres (16 à 19) étant rendus étanches au moyen de joints toriques (37).
